# EUROPEAN PATENT SPECIFICATION

(11) **EP 4 107 788 B1**
(45) Date of publication and mention of the grant of the patent: **20.03.2024**
(21) Application number: 21710131.0
(22) Date of filing: 10.02.2021
(51) Int. Cl.: H01L 31/0224

(54) **SOLAR CELL AND METHOD FOR MANUFACTURING THE SAME**
SOLARZELLE UND VERFAHREN ZUR HERSTELLUNG DAVON
CELLULE SOLAIRE ET PROCÉDÉ DE FABRICATION ASSOCIÉ

(30) Priority: 18.02.2020 US 202062977997 P
(43) Date of publication of application: 28.12.2022
(73) Proprietor: Solar Paste, LLC, Wilmington, Delaware 19801 (US)
(72) Inventor: LEE, Chu-Yi, Taoyuan District 330 Taoyuan City (TW); MATSUURA, Yumi, Kanagawa 213-0012 (JP); SHIH, Che-Hsiu, Taoyuan District 330 Taoyuan City (TW); CHANG, Wei Hsuan, Taoyuan District 330 Taoyuan City (TW)
(74) Representative: Patentanwälte Olbricht Buchhold Keulertz
(86) International application number: PCT/US2021/017318
(87) International publication number: WO 2021/167818

(56) References cited:
- US-A1- 2011 308 601
- US-A1- 2012 037 219
- US-A1- 2018 097 128

## Description

### FIELD OF THE INVENTION

This invention relates to a conductive paste for solar cells and, in particular, relates to the reduction of silver consumption in the conductive paste for solar cells.

### TECHNICAL BACKGROUND OF THE INVENTION

In the solar cell industry, there has been increasingly fierce competition for better power generation efficiency. Even a 0.1% improvement in efficiency is sought as the efficiency becomes close to the theoretical limit.

At the same time, solar cell manufacturers have also sought cost reduction. As silver, which is typically used in finger electrodes and busbar electrodes, is expensive, it would be beneficial to reduce silver usage in electrodes or to substitute silver with an inexpensive metal. However, it is not been possible to reduce silver content without compromising efficiency.

US20100096014 discloses a conductive paste for solar cells, comprising conductive particles, glass frits, an organic binder and a solvent, wherein the conductive particles comprise (A) silver, and (B) one or more metals selected from the group consisting of copper, nickel, aluminum, zinc, and tin, and the weight proportion (A):(B) is 5:95 to 90:10.

US20140026953 discloses an electroconductive paste composition comprising: (a) electroconductive metal particles; (b) glass frit; and (c) an organic vehicle; wherein the electroconductive metal particles comprise a mixture of silver powder and at least one selected from the group consisting of nickel powder, tin (IV) oxide powder, and core-shell particles comprising a silver shell and a core of nickel and/or tin (IV) oxide.

Also document US 2011/0308601 A1 discloses a prior art solar cell.

### SUMMARY OF THE INVENTION

In one aspect according to claim 1, there is provided a solar cell, comprising: a silicon substrate, wherein the silicon substrate has a front side and a rear side; a finger electrode formed on the front side of the silicon substrate, wherein the finger electrode is in electric contact with the silicon substrate, wherein the finger electrode comprises a silver component and a glass binder, and wherein the finger electrode is substantively free of conductive metals other than the silver component; and a busbar electrode formed on the front side of the silicon substrate, wherein the busbar electrode is in electric contact with the finger electrode and wherein the busbar electrode comprises a silver component, a second metal selected from the group consisting of nickel, copper, alloys thereof, and mixtures thereof, and a glass binder.

Another aspect according to claim 7, provides a method for manufacturing solar cells, comprising the steps of: providing a silicon substrate, wherein the silicon substrate has a front side and a rear side; applying a first conductive paste for forming a busbar electrode on the front side of the silicon substrate, wherein the first conductive paste comprises: (a) 68 to 88 wt% of a silver component; (b) 1 to 30 wt% of a metal powder selected from the group consisting of nickel, copper, alloys thereof, and mixtures thereof; (c) 0.1-3.3 wt% of a glass binder, and (d) 3 to 23 wt% of an organic vehicle; wherein wt% is based on the total weight of the paste composition; applying a second conductive paste for forming a finger electrode on the front side of the silicon substrate, wherein the conductive paste comprises (a) 70 to 95 wt% of a silver component; (b) 0.6 to 7 wt% of a glass binder; and (c) 3 to 23 wt% of an organic vehicle; wherein wt% is based on the total weight of the paste composition, wherein the second conductive paste for the finger electrode is substantively free of other conductive metals than the silver component; firing the applied conductive pastes to form the finger electrode and the busbar electrode on the front side of the silicon substrate.

### BRIEF DESCRIPTION OF THE DRAWINGS

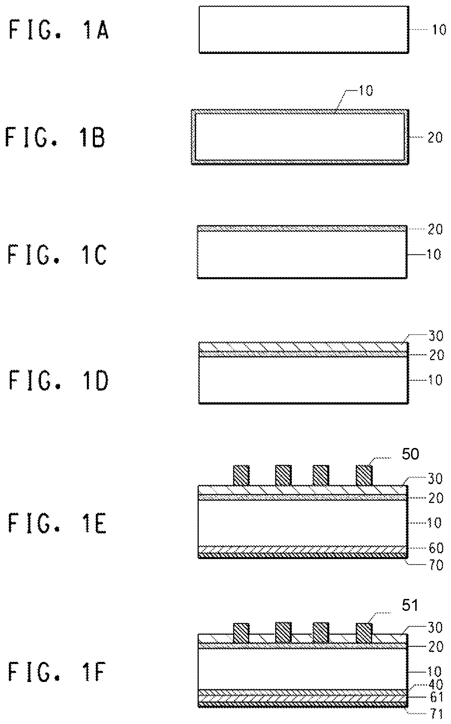

FIGS. 1A to 1F are drawings for explaining a solar cell electrode manufacturing process. FIG. 1A shows a p-type silicon substrate 10. FIG. 1B shows the silicon substrate coated with an n-layer 20. FIG. 1C shows the silicon substrate having the n-layer only on the front side. FIG. 1D shows the silicon substrate with a passivation layer 30. FIG. 1E shows the silicon substrate with a conductive paste 50 on the front side and an aluminum paste 60 and a silver paste 70 on the rear side. FIG. 1F shows the silicon substrate after firing.

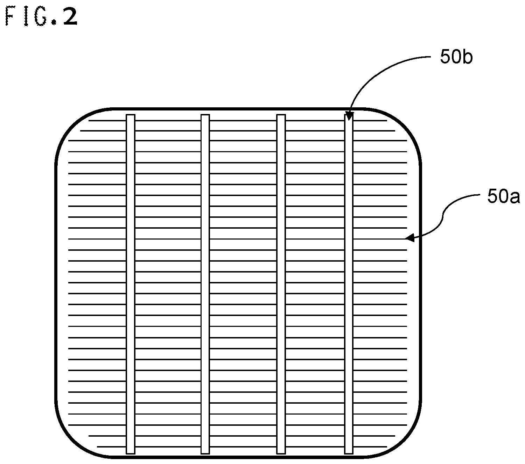

FIG. 2 shows the front side of a solar cell having a plurality of finger electrodes 50a and a plurality of busbar electrodes 50b.

### DETAILED DESCRIPTION OF THE INVENTION

The following shows embodiments of solar cells and manufacturing process of solar cells. However, the invention is not limited to the following embodiments. It should be understood that although the present invention has been specifically disclosed by preferred embodiments, optional features, modification, improvement and variation of the invention may be resorted to by those skilled in the art, and that such modifications, improvements and variations are considered to be within the scope of this invention.

### (Method of Manufacturing Solar Cells)

The method of manufacturing solar cells comprises steps of: providing a silicon substrate, printing pastes to form the electrodes, and then firing the applied conductive pastes. A dual step printing technique is commonly used, wherein a first conductive paste is applied for forming a busbar electrode on the front side of the silicon substrate, and then a second conductive paste is applied for forming a finger electrode on the front side of the silicon substrate. Alternatively, the finger electrode may be printed first and then busbar electrode.

FIG. 1A shows a p-type silicon substrate 10 in this embodiment. The present invention can be applied for other types of solar cells. For instance, a n-type silicon substrate may be used, in which case, the opposite type of doping would typically be used in the following processes.

The silicon substrate has a front side and a rear side. The front side is defined as the sun-light receiving side the finished solar cell is disposed for electricity generation.

In FIG. 1B, an n-layer 20, of the reverse conductivity type is formed by the thermal diffusion of phosphorus (P) or the like in this particular embodiment. Phosphorus oxychloride (POCl₃) is commonly used as the phosphorus diffusion source. In the absence of any particular modification, n-layer 20 is formed over the entire surface of the silicon substrate 10. The silicon wafer consists of p-type substrate 10 and n-layer 20 typically has a sheet resistivity on the order of several tens of ohms per square (ohm/□).

After protecting one surface of the n-layer with a resist or the like, the n-layer 20 is removed from most surfaces by etching so that it remains only on one main (front or sunlight-receiving) surface as shown in FIG. 1C. The resist is then removed using a solvent or a remover.

Next, a passivation layer 30 can be formed on the n-layer 20 as shown in FIG. 1D by a process such as plasma chemical vapor deposition (CVD) in this embodiment. SiNx, TiO₂, Al₂O₃, SiOx or indium tin oxide (ITO) could be used as a material for a passivation layer. Commonly used material is Si₃N₄. The passivation layer is sometimes called an anti-reflection layer, especially when it is formed on the front, light receiving side of the silicon substrate.

As shown in FIG. 1E, an aluminum paste, 60, and a silver paste, 70, are screen printed onto the back side of the substrate, 10, and successively heated at 60 to 300 °C to dry the printed paste. The electrode formation on the back side may be done after the electrode formation on the front side.

Conductive paste 50 is applied on the passivation layer 30, and then dried. On the front side of solar cells, two types of electrodes are typically formed as illustrated in FIG. 2. One is called finger electrode 50a. Ordinarily, a large plurality of finger electrodes 50a are included, as depicted in FIG. 2. The other is called busbar electrode 50b, with one or more typically being used. An important function of the finger electrodes is to collect electricity generated in the silicon substrate. Collected electricity flows through the busbar electrodes for external input/output. The finger electrodes need to be in electric contact with the doped layer formed on the surface of the silicon substrate. In the embodiment of Fig. 1, the finger electrodes are in electric contact with the n-layer 20. Electric contact of the busbar electrodes with the silicon substrate is not necessarily needed. In other words, the finger electrodes need to penetrate the passivation layer 30 while the busbar electrodes do not necessarily need to do so.

In the present invention, different types of the conductive pastes are used for the finger electrodes and the busbar electrodes. The conductive paste for the finger electrodes contains a high amount of silver component for better conductivity and contains a certain amount of glass binder for electric connection with the silicon substrate.

The finger electrodes are substantively free of conductive metals other than the silver component. "Substantively free" herein means the content is less than 1wt% in an embodiment, less than 0.5wt% in an embodiment, less than 0.1wt% in an embodiment, and untraceable in an embodiment. In an embodiment, no conductive metals other than the silver component is intentionally added. Glass binders are not included in the definition of conductive metal as the glass binders that basically consists of inorganic oxides have low conductivity.

In an embodiment, the finger electrodes do not contain any metal element selected from the group consisting of nickel (Ni), copper (Cu), gold (Au), platinum (Pt), palladium (Pd), aluminum (Al), an alloy and a mixture thereof.

In another embodiment, the finger electrodes do not contain any conductive component with an electrical conductivity of 1.00×10⁷ Siemens (8)/m or more at 293 Kelvin other than the silver component. Such conductive metals includes, for example, iron (Fe; 1.00×10⁷ S/m), aluminum (Al; 3.64×10⁷ S/m), nickel (Ni; 1.45×10⁷ S/m), copper (Cu; 5.81×10⁷ S/m), gold (Au; 4.17×10⁷ S/m), molybdenum (Mo; 2.10×10⁷ S/m), magnesium (Mg; 2.30×10⁷ S/m), tungsten (W; 1.82×10⁷ S/m), cobalt (Co; 1.46×10⁷ S/m) and zinc (Zn; 1.64×10⁷ S/m).

The finger electrode, after firing, contains 80 to 99.5 wt% of the silver component and 0.5 to 20 wt% of the glass binder based on the total weight of the finger electrode in an embodiment. The content of the silver component is 90 to 99 wt% in an embodiment and 95 to 98.5 wt% in another embodiment. The content of the glass binder is 1 to 10 wt% in an embodiment and 1.5 to 5 wt% in another embodiment.

On the other hand, the busbar electrodes contain a silver component as well as a second metal. The second metal is nickel in an embodiment. The second metal is copper in an embodiment. Both nickel and copper are used as alloy or mixture in another embodiment. The busbar electrodes may contain a lesser amount of glass binder than the finger electrodes in an embodiment, rendering the busbar electrode more electrically conductive. The busbar electrodes are in electric contact with the finger electrodes.

The busbar electrodes, after firing, contain 74 to 98 wt% of the silver component, 2 to 25 wt% of the second metal and 0.1 to 3 wt% of the glass binder based on the total weight of the busbar electrode in an embodiment. The content of the silver component is 80 to 97 wt% in an embodiment and 85 to 95 wt% in another embodiment. The content of the second metal is 3 to 20 wt% in an embodiment and 5 to 15 wt% in another embodiment. The content of the glass binder is 0.15 to 2 wt% in an embodiment and 0.2 to 1 wt% in another embodiment.

Wt% in the glass and metals of the finger or busbar electrode can be measured by Inductively coupled plasma mass spectrometry (ICP-MS).

Four to twelve lines of the busbar electrodes are typically formed on the silicon substrate. Dozens of the finger electrodes are typically formed on the silicon substrate, depending on the size of the silicon substrate. To promote high efficiency of the solar cell, it is desired that the fraction of the area of the silicon substrate covered with the finger electrodes and the busbar electrodes be minimized. Typically, the line width of the finger electrodes is narrow while the busbar electrodes have a wider pattern. The width of the finger electrodes can be 10 to 45 µm in an embodiment, 20 to 43 µm in another embodiment, 30 to 41 µm in another embodiment. The width of the busbar electrodes can be 0.3 to 1.5 mm in an embodiment, 0.4 to 1.2 mm in another embodiment, 0.5 to 1 mm in another embodiment.

The electrodes are formed by heating the printed conductive paste. In an embodiment, heating is carried out in an infrared furnace, such as a belt-type furnace, at a peak temperature in a range of 450 °C to 1000 °C as it is called firing. For a belt furnace, the peak temperature is understood to be the set point in the hottest zone of the furnace. The total time of heating from an entrance to an exit of the furnace can be from 30 seconds to 5 minutes in an embodiment. With such heating condition, a silicon substrate can get less damage from the heat. In an embodiment, the heating profile can be 10 to 60 seconds at over 400 °C and 2 to 10 seconds at over 600 °C.

As shown in FIG. 1F, during firing, aluminum diffuses as an impurity from the aluminum paste into the silicon substrate 10 on the back side, thereby forming a p+ layer 40 that contains a high aluminum dopant concentration. Firing converts the dried aluminum paste 60 to an aluminum back electrode 61. The backside silver paste 70 is fired at the same time, becoming a silver back electrode 71. During firing, the boundary between the backside aluminum and the backside silver assumes the state of an alloy, thereby achieving electrical connection. Most areas of the back electrode are occupied by the aluminum electrode, partly on account of the need to form a p+ layer 40 in an embodiment. At the same time, because soldering to an aluminum electrode is not easy, silver paste 70 is used to form a backside electrode 71 on a limited area of the backside as an electrode for interconnecting solar cell cells by means of copper ribbon or the like in an embodiment.

On the front side, the front electrode 51 is made from the conductive paste 50. At least the finger electrode 50a is capable of firing through the passivation layer 30 during the firing to achieve electrical contact with the n-type layer 20 as shown in FIG. 1F. The penetrating function of the conductive paste is called 'fire through.' The busbar electrodes 50b does not fire through the passivation layer 30 in an embodiment. Due to the reduced amount of glass binder in the busbar electrode, the busbar electrodes can have higher conductivity, enabling the use of other less conductive and less expensive metals in the busbar electrode.

Although a p-base type of solar cell is shown as an example, the present invention can be available for an n-base type of solar cell or any other type of a solar cell using a conductive paste.

Next, the first conductive paste and the second conductive paste, which are used for making the solar cells of the present invention, are described.

### (Finger Conductive Paste)

Finger conductive paste to form the finger electrodes comprises a silver component; (b) a glass binder; and (c) an organic vehicle.

### (i) Silver Component

The silver component enables the paste to transport electrical current. The silver component can sinter without forming oxides after firing in air to provide highly conductive bulk material. The silver component can comprise powders that are flaky or spherical in shape, or both.

The silver component is substantively silver powder in an embodiment. The silver powder contains 90% or more of silver element in an embodiment, 95% or more in another embodiment and 99% or more in another embodiment based on the total content of the silver powder.

The silver component is a silver-containing alloy in an embodiment. The silver-containing alloy contains 50% or more of silver element in an embodiment, 70% or more in another embodiment and 90% or more in another embodiment based on the total content of the silver-containing alloy. The silver-containing alloy is silver-copper alloy, silver-gold alloy, silver-platinum alloy, silver-copper-gold alloy or silver-copper-germanium alloy in an embodiment.

The silver component is a silver-coated powder in an embodiment such as silver-copper core-shell particles. The silver-coated powder contains 50% or more of silver element in an embodiment, 70% or more in another embodiment and 90% or more in another embodiment based on the total content of the silver-coated powder.

Two or more kinds of the silver powder, the silver-containing alloy and the silver-coated powder can be used together.

The silver component is 70 to 95 weight percent (wt %) in an embodiment, 75 to 93 wt % in another embodiment, and 80 to 91 wt % in another embodiment, based on the total weight of the conductive paste. A silver component with such amount in the conductive paste can retain sufficient conductivity for solar cell applications.

The particle diameter of the silver component is 0.1 to 10 µm in an embodiment, 0.5 to 7 µm in another embodiment, and 1 to 4 µm in another embodiment. The silver component with such particle diameter can be adequately dispersed in the organic binder and solvent, and smoothly applied onto the substrate. In an embodiment, the silver component can be a mixture of two or more types of silver components with different particle diameters or different particle shapes.

The particle diameter is obtained by measuring the distribution of the particle diameters by using a laser diffraction scattering method and can be specified by D50, which means a cumulative 50% point of diameter (or 50% pass particle size in the distribution. The particle size distribution can be measured with a commercially available device, such as the Microtrac model X-100.

The conductive paste for the finger electrodes is substantively free of other conductive metals than the silver component. "Substantively free" herein means the content is less than 1wt% in an embodiment, less than 0.5wt% in an embodiment, less than 0.1wt% in an embodiment and untraceable in an embodiment. Glass binders, which are described below, are not included in the definition of conductive metal, as glass binders ordinarily consist of inorganic oxides that have little or no conductivity.

In an embodiment, the conductive paste for the finger electrodes does not contain any metal element selected from the group consisting of nickel (Ni), copper (Cu), gold (Au), platinum (Pt), palladium (Pd), aluminum (Al), and any mixture thereof.

In another embodiment, the conductive paste for the finger electrodes does not contain any conductive component with an electrical conductivity of 1.00×10⁷ Siemens (8)/m or more at 293 Kelvin other than the silver component. Such conductive metals includes, for example, iron (Fe; 1.00×10⁷ S/m), aluminum (Al; 3.64×10⁷ S/m), nickel (Ni; 1.45×10⁷ S/m), copper (Cu; 5.81×10⁷ S/m), gold (Au; 4.17×10⁷ S/m), molybdenum (Mo; 2.10×10⁷ S/m), magnesium (Mg; 2.30×10⁷ S/m), tungsten (W; 1.82×10⁷ S/m), cobalt (Co; 1.46×10⁷ S/m) and zinc (Zn; 1.64×10⁷ S/m).

### (ii) Glass Binder

Glass binders, which are often called glass frits when mixed in a paste, help to form an electrical contact through the passivation layer during the consequent firing process. They also facilitate binding of the electrode to the silicon substrate. The glass binder comprises inorganic oxides. The glass binder is composed of 90 wt% or more of inorganic oxides in an embodiment, 95 wt% or more of inorganic oxides in another embodiment, 98 wt% or more of inorganic oxides in another embodiment and 100 wt% of inorganic oxides in another embodiment. The glass binders may also promote sintering of the conductive powder in an embodiment.

The content of the glass binder is 0.6 to 7 wt% in an embodiment, based on the total weight of the conductive paste. The content is 0.8 to 6 wt % in another embodiment, and 1 to 5 wt% in another embodiment, based on the total weight of the conductive paste. By adding glass binder with such high amount, electrical properties of the solar cell can be improved.

Composition of the glass binder is not limited to a specific composition. A lead-free glass or a lead containing glass can be used, for example.

In one embodiment, the glass binder comprises a lead containing glass frit containing lead oxide and one or more of oxides selected from the group consisting of tellurium oxide (TeO₂) and bismuth oxide (Bi₂O₃). Lead oxide (PbO) is 17 to 47 wt% in an embodiment, and 22 to 42 wt% in another embodiment, and 25 to 39 wt% in another embodiment based on the total weight of the glass binder.

Tellurium oxide (TeO₂) is 17 to 47 wt% in an embodiment, and 22 to 42 wt% in another embodiment, and 25 to 39 wt% in another embodiment, based on the total weight of the glass binder.

Bismuth oxide (Bi₂O₃) is 8 to 24 wt % in an embodiment, 11 to 25 wt % in another embodiment, and 13 to 23 wt % in another embodiment, based on the total weight of the glass binder.

In another embodiment, the glass binder further comprises an inorganic oxide selected from the group consisting SiO₂, Li₂O, Na₂O, B₂O₃, WO₃, CaO, Al₂O₃, ZnO, MgO, TiO₂, ZrO₂, BaO, MgO, K₂O, CuC, AgO, and any mixture thereof.

The glass binder can be prepared by methods well known in the art. For example, the glass binder or glass frit can be prepared by mixing and melting raw materials such as oxides, hydroxides, carbonates, making into a cullet by quenching, followed by mechanical pulverization (wet or dry milling). Thereafter, if needed, classification is carried out to the desired particle size.

### (iii) Organic Vehicle

The conductive paste comprises an organic vehicle, which comprises an organic binder and a solvent.

In one embodiment, the organic binder can comprise ethyl cellulose, ethylhydroxyethyl cellulose, Foralyn^{™} (pentaerythritol ester of hydrogenated rosin), dammar gum, wood rosin, phenolic resin, acryl resin, polymethacrylate of lower alcohol or a mixture thereof.

In one embodiment, the solvent can comprise terpenes such as alpha- or beta-terpineol or mixtures thereof, Texanol^{™} (2,2,4-trimethy-1,3-pentanediolmonoisobutyrate), kerosene, dibutylphthalate, butyl Carbitol^{™}, butyl Carbitol^{™} acetate, hexylene glycol, monobutyl ether of ethylene glycol monoacetate, diethylene glycol monobutyl ether, diethylene glycol monobutyl ether acetate, diethylene glycol dibutyl esther, bis (2-(2-butoxyethoxy)ethyl) adipate, dibasic esters such as DBE^{®}, DBE^{®}-2, DBE^{®}-3, DBE^{®}-4, DBE^{®}-5, DBE^{®}-6, DBE^{®}-9, and DBE^{®}-1B from Invista, octyl epoxy tallate, isotetradecanol, and petroleum naphtha, or a mixture thereof.

The amount of organic vehicle is 3 to 23 wt % in one embodiment, 5 to 20 wt % in another embodiment, 7 to 18 wt % in further embodiment, based on the total weight of the conductive paste.

The organic vehicle can be burned off during the firing step so that the formed electrode ideally contains no organic residue. However, a certain amount of residue can remain in the resulting electrode as long as it does not degrade the electrical properties.

### (iv) Additives

Additives such as any of a thickener, a stabilizer, a dispersant, a viscosity modifier and a surfactant can be added to a conductive paste as the need arises. The amount of the additives depends on the desired characteristics of the resulting conductive paste and can be chosen by people in the industry. Multiple kinds of the additives can be added to the conductive paste.

Although components of the conductive paste for the finger electrode were described above, the conductive paste can contain impurities coming from raw materials or contamination during the manufacturing process. The presence of the impurities would be allowed (defined as benign) as long as it does not significantly alter anticipated properties of the conductive paste. The finger electrode manufactured with the conductive paste can achieve sufficient electric properties described herein, even if the conductive paste includes benign impurities.

### (v) Viscosity and solid content

The viscosity of the conductive paste is 100 to 600 Pa.s in one embodiment, 150 to 500 Pa·s in another embodiment, 200 to 400 Pa·s in a further embodiment. Such viscosities are typically found to provide excellent printability.

In the present invention, the viscosity of the conductive paste is defined as a value obtained by measurement at 25°C, 10 rpm using a Brookfield HBT viscometer with a #14 spindle and a SC4-14/6R utility cup.

The inorganic solids content of the conductive paste is calculated as the percentage (wt%) of inorganic solids relative to the total weight of the conductive paste. The inorganic solids typically consist of conductive metal/alloy powders and glass binder. In one embodiment, the inorganic solids content is 68.5 to 96.7 wt%, and 85 to 94 wt% in another embodiment, based on the total weight of the conductive paste.

### (Busbar Conductive Paste)

Busbar conductive paste to form the busbar electrodes comprises a silver component; (b) a second metal, (c) a glass binder; and (d) an organic vehicle.

### (i) Silver Component

The silver component enables the paste to transport electrical current. The silver component can sinter without forming oxides after firing in air to provide highly conductive bulk material. The silver component can comprise powders that are flaky or spherical in shape, or both.

The silver component is substantively silver powder in an embodiment. The silver powder contains 90% or more of silver element in an embodiment, 95% or more in another embodiment and 99% or more in another embodiment based on the total content of the silver powder.

The silver component is a silver-containing alloy in an embodiment. The silver-containing alloy contains 50% or more of silver element in an embodiment, 70% or more in another embodiment and 90% or more in another embodiment based on the total content of the silver-containing alloy. The silver-containing alloy is silver-copper alloy, silver-gold alloy, silver-platinum alloy, silver-copper-gold alloy or silver-copper-germanium alloy in an embodiment.

The silver component is a silver-coated powder in an embodiment such as silver-copper core-shell particles. The silver-coated powder contains 50% or more of silver element in an embodiment, 70% or more in another embodiment and 90% or more in another embodiment based on the total content of the silver-coated powder.

Two or more kinds of the silver powder, the silver-containing alloy and the silver-coated powder can be used together.

The silver component is 68 to 88 weight percent (wt%) in an embodiment, 72 to 87 wt% in another embodiment, and 77 to 85 wt% in another embodiment, based on the total weight of the conductive paste. A silver component with such amount in the conductive paste can retain sufficient conductivity required for the busbar electrode.

The particle diameter of the silver component is 0.1 to 10 µm in an embodiment, 0.5 to 7 µm in another embodiment, and 1 to 4 µm in another embodiment. The silver component with such particle diameter can be adequately dispersed in the organic binder and solvent, and smoothly applied onto the substrate. In an embodiment, the silver component can be a mixture of two or more types of silver components with different particle diameters or different particle shapes.

The particle diameter is obtained by measuring the distribution of the particle diameters by using a laser diffraction scattering method and can be specified by D50, which means a cumulative 50% point of diameter (or 50% pass particle size in the distribution. The particle size distribution can be measured with a commercially available device, such as the Microtrac model X-100.

### (ii) Second Metal

Using a second metal the busbar electrode allows the present solar cell to be made at lower cost, by reducing the amount of expensive noble metal required, while maintaining cell performance. The second metal is selected from the group consisting of nickel, copper, alloy thereof and mixture thereof. The second metal component can comprise powder that is flaky or spherical in shape, or both.

The second metal powder is substantively nickel powder in an embodiment. The second metal powder contains 90% or more of nickel element in an embodiment, 95% or more in another embodiment and 99% or more in another embodiment based on the total content of the second metal powder.

The second metal powder is substantively copper powder in an embodiment. The second metal powder contains 90% or more of copper element in an embodiment, 95% or more in another embodiment and 99% or more in another embodiment based on the total content of the second metal powder.

The second metal powder is a nickel-containing alloy or a copper-containing alloy in an embodiment. The nickel-containing alloy contains 50% or more of nickel element in an embodiment, 70% or more in another embodiment and 90% or more in another embodiment based on the total content of the nickel-containing alloy. The copper-containing alloy contains 50% or more of copper element in an embodiment, 70% or more in another embodiment and 90% or more in another embodiment based on the total content of the copper-containing alloy.

The second metal powder is a nickel-coated powder or a copper-coated powder in an embodiment. The nickel-coated powder contains 50% or more of nickel element in an embodiment, 70% or more in another embodiment and 90% or more in another embodiment based on the total content of the nickel-coated powder. The copper-coated powder contains 50% or more of copper element in an embodiment, 70% or more in another embodiment and 90% or more in another embodiment based on the total content of the copper-coated powder.

Two or more kinds of the second metal powders can be used together.

The second metal powder is 1 to 30 weight percent (wt%) in an embodiment, 5 to 20 wt% in another embodiment, and 7 to 15 wt% in another embodiment, based on the total weight of the conductive paste. The second metal powder with such amount in the conductive paste can retain sufficient conductivity for solar cell applications while contributing to the competitiveness of manufactured solar cells.

The particle diameter of the second metal powder is 0.1 to 10 µm in an embodiment, 0.5 to 7 µm in another embodiment, and 1 to 4 µm in another embodiment. The second metal powder with such particle diameter can be adequately dispersed in the organic binder and solvent, and smoothly applied onto the substrate. In an embodiment, the second metal powder can be a mixture of two or more types of second metals with different particle diameters or different particle shapes.

The particle diameter measurement is obtained by SEM image analysis of 25 to 30 particles. Average particle size can be calculated by measuring diameters of 25 to 35 primary particles and taking the number-average in a 4000x magnitude SEM image. The SEM image can be obtained with a commercially available device, such as Hitachi SEM model 3500.

### (iii) Glass Binder

Glass binders, which are often called glass frits when mixed in a paste, help to form an electrical contact through the passivation layer during the consequent firing process. They facilitate binding of the electrode to the silicon substrate. The glass binder comprises inorganic oxides. The glass binder is composed of 90wt% or more of inorganic oxides in an embodiment, 95wt% or more of inorganic oxides in another embodiment, 98wt% or more of inorganic oxides in another embodiment and 100wt% of inorganic oxides in another embodiment. The glass binders may also promote sintering of the conductive powder in an embodiment.

The content of the glass binder is 0.1 to 3.3 wt% in an embodiment, based on the total weight of the conductive paste. The content of the glass binder can be reduced in the busbar electrodes as sufficient electrical connection with the silicon substrate is achieved through the finger electrodes. The content is 0.15 to 2.2 wt % in another embodiment, and 0.2 to 1.2 wt% in another embodiment, based on the total weight of the conductive paste.

Composition of the glass binder is not limited to a specific composition. A lead-free glass or a lead containing glass can be used, for example.

In one embodiment, the glass binder comprises a lead containing glass frit containing lead oxide and one or more of oxides selected from the group consisting of silicon oxide (SiO₂) and boron oxide (B₂O₃).

Lead oxide (PbO) is 30 to 80 wt% in an embodiment, and 37 to 73 wt% in another embodiment, and 45 to 68 wt% in another embodiment based on the total weight of the glass binder.

Silicon oxide (SiO₂) is 5 to 25 wt% in an embodiment, 8 to 20 wt% in another embodiment, and 10 to 18 wt% in another embodiment, based on the total weight of the glass binder.

Boron oxide (B₂O₃) is 2 to 15 wt% in an embodiment, 3 to 12 wt% in another embodiment, and 5 to 10 wt% in another embodiment, based on the total weight of the glass binder.

In another embodiment, the glass binder further comprise an inorganic oxide selected from the group consisting TeO₂, Li₂O, Na₂O, Bi₂O₃, WO₃, CaO, Al₂O₃, ZnO, MgO, TiO₂, ZrO₂, BaO, MgO, K₂O, CuO, AgO, and any mixture thereof.

The glass binder can be prepared by methods well known in the art. For example, the glass binder or glass frit can be prepared by mixing and melting raw materials such as oxides, hydroxides, carbonates, making into a cullet by quenching, followed by mechanical pulverization (wet or dry milling). Thereafter, if needed, classification is carried out to the desired particle size.

### (iv) Organic Vehicle

The conductive paste comprises an organic vehicle, which comprises an organic binder and a solvent.

In one embodiment, the organic binder can comprise ethyl cellulose, ethylhydroxyethyl cellulose, Foralyn^{™} (pentaerythritol ester of hydrogenated rosin), dammar gum, wood rosin, phenolic resin, acryl resin, polymethacrylate of lower alcohol or a mixture thereof.

In one embodiment, the solvent can comprise terpenes such as alpha- or beta-terpineol or mixtures thereof, Texanol^{™} (2,2,4-trimethy-1,3-pentanediolmonoisobutyrate), kerosene, dibutylphthalate, butyl Carbitol^{™}, butyl Carbitol^{™} acetate, hexylene glycol, monobutyl ether of ethylene glycol monoacetate, diethylene glycol monobutyl ether, diethylene glycol monobutyl ether acetate, diethylene glycol dibutyl esther, bis (2-(2-butoxyethoxy)ethyl) adipate, dibasic esters such as DBE^{®}, DBE^{®}-2, DBE^{®}-3, DBE^{®}-4, DBE^{®}-5, DBE^{®}-6, DBE^{®}-9, and DBE^{®}-1B from Invista, octyl epoxy tallate, isotetradecanol, and petroleum naphtha, or a mixture thereof.

The amount of organic vehicle is 3 to 23 wt % in one embodiment, 5 to 20 wt % in another embodiment, 7 to 18 wt % in further embodiment, based on the total weight of the conductive paste.

The organic vehicle can be burned off during the firing step so that the formed electrode ideally contains no organic residue. However, a certain amount of residue can remain in the resulting electrode as long as it does not degrade the electrical properties.

### (v) Additives

Additives such as any of a thickener, a stabilizer, a dispersant, a viscosity modifier and a surfactant can be added to a conductive paste as the need arises. The amount of the additives depends on the desired characteristics of the resulting conductive paste and can be chosen by people in the industry. Multiple kinds of the additives can be added to the conductive paste.

Although components of the conductive paste for the busbar electrode were described above, the conductive paste can contain impurities coming from raw materials or contamination during the manufacturing process. The presence of the impurities would be allowed (defined as benign) as long as it does not significantly alter anticipated properties of the conductive paste. The busbar electrode manufactured with the conductive paste can achieve sufficient electric properties described herein, even if the conductive paste includes benign impurities.

### (vi) Viscosity and solid content

The viscosity of the conductive paste is 100 to 600 Pa·s in one embodiment, 150 to 500 Pa·s in another embodiment, 200 to 400 Pa·s in further embodiment. Such viscosities are typically found to provide excellent printability.

The inorganic solids content of the conductive paste is calculated as the percentage (wt%) of inorganic solids relative to the total weight of the conductive paste. The inorganic solids typically consist of conductive metal/alloy powders and glass binder. In one embodiment, the inorganic solids content is 68.5 to 96.7 wt%, and 85 to 94 wt% in another embodiment, based on the total weight of the conductive paste.

### EXAMPLES

The present invention is illustrated by, but is not limited to, the following examples. "Parts" in the examples means parts by weight.

### Example 1

### 1. Preparation of busbar paste

An organic vehicle, which is composed of Butyl Carbitol^{™} Acetate, DBE-3, Texanol^{™}, Ethyl Cellulose, Foralyn, and additives, was mixed with the viscosity modifier for 15 minutes. To enable a uniform dispersion, the glass frit of 0.6 parts was dispersed in the organic vehicle of 17.4 parts and mixed for 15 minutes. The glass frit was PbO-SiO₂-B₂O₃-type. Then, 8.2 parts of a nickel (Ni) powder was incrementally added, followed by incremental addition of 73.8 parts of silver powder. Particle diameter (number average) of the Ni powder was 4 µm as measured by SEM image analysis. The shape of the Ni powder was rough cubical. The Ag powder was a spherical powder with particle diameter (D50) of 1.2 µm as measured with a laser diffraction scattering method. The mixture was repeatedly passed through a 3-roll mill at progressively increasing pressures from 0 to 400 psi. The gap of the rolls was adjusted to 1 mil.

Finally, additional organic medium or thinners were mixed to adjust the viscosity of the paste. The viscosity measured at 10 rpm and 25°C with a Brookfield HBT viscometer and #14 spindle and a SC4-14/6R utility cup was 300 Pa·s.

### 2. Manufacturing of solar cell

The printing work was conducted by Baccini printer (made by Applied materials). The busbar pastes obtained above and a commercially available finger paste (DuPont PV22A) were sequentially screen printed with the desired busbar and finger pattern onto a wafer. The finger paste PV22A is a silver paste, containing no other conductive component. The wafer was P-type mono crystal PERC (Passivated Emitter Rear Cell) cell obtained from Inventec Solar Energy Corporation. The busbar screen was 400 mesh, 18 µm wire diameter, 10 µm emulsion thickness (manufactured by Murakami screen). The finger screen was 440 mesh, 13 µm wire diameter, 12 µm emulsion thickness (manufactured by Murakami screen).

The printed pastes were dried at 200°C for 30 secs in a belt furnace, then fired in an IR heating type of belt furnace (CF-7210B, Despatch industry) at peak temperature setting with 895°C to form finger electrodes and busbar electrodes. The furnace set temperature of 895°C corresponded to a measured temperature at the upper surface of the silicon substrate of 728°C. Firing time from furnace entrance to exit was 72 seconds. The firing profile had a ramping rate from 400 to 600°C in 7 seconds, and the period over 600°C for 4.7 seconds. The temperature was measured at the upper surface of the silicon substrate with a K-type thermocouple and recorded using an environmental data logger (Datapaq^{®} Furnace Tracker^{®} System, Model DP9064A, Datapaq Ltd.). The belt speed of the furnace was 660 cpm.

### 3. Test Procedure

### 3-1. IV characteristics

The manufactured solar cell was tested for efficiency with a commercial IV tester (FRIWO^{®}, BERGER Corporation). The Xe Arc lamp in the IV tester simulates the sunlight with a known intensity and spectrum with air mass value of 1.5 to irradiate the p-type emitter side of the n-base solar cell. The tester used a "four-point probe method" to measure current (I) and voltage (V) at approximately 400 load resistance settings to determine the cell's I-V curve. The busbars formed on the front side of the cells were connected to the multiple probes of the IV tester and the electrical signals were transmitted through the probes to the data processing computer to obtain solar cell's I-V characteristics, including the short circuit current, the open circuit voltage, the fill-factor (FF), series resistance, and the cell efficiency.

### 3-2. Peeling force

Copper ribbons were soldered to the busbars of the test solar cells at 180°C using 952-S soldering flux (Kester). A 180 degree peel adhesion test is then conducted. At least three samples were tested for calculating the average peeling force.

### Example 2

A solar cell was manufactured in the same way as in Example 1, except that the nickel (Ni) powder used had a particle diameter (number average) of 2.5 µm instead of 4 µm. The shape of the Ni powder was rough irregular. The solar cell was tested for IV characteristics and peeling force according to the procedure used for Example 1.

### Example 3

A solar cell was manufactured in the same way as in Example 1, except that a copper (Cu) powder with particle diameter (number average) of 2 µm was used instead of Ni powder. The shape of the Cu powder was smooth spherical. The solar cell was tested for IV characteristics and peeling force according to the procedure used for Example 1.

### Comparative Example 1

A solar cell was manufactured in the same way as in Example 1, except that no second metal was used. The solar cell was tested for the IV characteristics and peeling force according to the procedure used for Example 1.

### Comparative Example 2

A solar cell was manufactured in the same way as in Example 1, except that an alumina (Al₂O₃) powder with particle diameter (number average) of 3 µm was used instead of Ni powder. The shape of the Al₂O₃ powder was smooth spherical. The solar cell was tested for IV characteristics and peeling force according to the procedure used for Example 1.

### Comparative Example 3

A solar cell was manufactured in the same way as in Example 1, except that an alumina (Al₂O₃) powder with particle diameter (number average) of 5 µm was used instead of Ni powder. The shape of the Al₂O₃ powder was smooth spherical. The solar cell was tested for IV characteristics and peeling force according to the procedure used for Example 1.

### Comparative Example 4

A solar cell was manufactured in the same way as in Example 1, except that an aluminum (Al) powder with particle diameter (number average) of 1.5 µm was used. The shape of the Al powder was smooth spherical. The solar cell was tested for IV characteristics and peeling force according to the procedure used for Example 1.

Table 1 below shows test results of the Examples and Comparative Examples. Example 1, Example 2, and Example 3 reached comparable efficiency relative to the Comparable Example 1, which contains no second metal. With 10wt% replacement of Ag with a Ni or Cu powder (i.e. 8.2wt% of 82wt% Ag in Comparative Example 1), the efficiency and peeling force had a minimum loss while the usage of precious metal, Ag, was significantly reduced. Each of Comparable Example 2 and Comparable Example 3 showed a significant efficiency loss due to FF downgrade. In Comparative Example 4, the IV characteristics could not be measured as the value was too low and the peeling force could not be measured, as the ribbon did not adhere to the electrodes.

**Table 1**

| | | Example 1 | Example 2 | Example 3 | Comparative Example 1 | Comparable example 2 | Comparable example 3 | Comparable example 4 |
|---|---|---|---|---|---|---|---|---|
| Finger Paste | | Ag paste | Ag paste | Ag paste | Ag paste | Ag paste | Ag paste | Ag paste |
| Busbar paste | | | | | | | | |
| | Silver Component | Ag 73.8wt% | Ag 73.8wt% | Ag 73.8wt% | Ag 82wt% | Ag 73.8wt% | Ag 73.8wt% | Ag 73.8wt% |
| | Second Metal or Metal Oxide | Ni 8.2wt% (4µm, Rough cubical) | Ni 8.2wt% (2.5µm, Rough irregular) | Cu 8.2wt% (2µm, Smooth spherical) | None | Al₂O₃ 8.2wt% (3µm, Smooth spherical) | Al₂O₃ 8.2wt% (5µm, Smooth spherical) | Al 8.2wt% (1.5µm, Smooth spherical) |
| Eff (%) | | 21.50 | 21.54 | 21.51 | 21.50 | 21.35 | 21.23 | Too low to measure |
| Voc (V) | | 0.6602 | 0.6612 | 0.6606 | 0.6608 | 0.6599 | 0.6598 | N/A |
| Isc (A) | | 9.859 | 9.848 | 9.852 | 9.844 | 9.847 | 9.851 | N/A |
| FF (%) | | 80.719 | 80.841 | 80.763 | 80.755 | 80.281 | 79.805 | N/A |
| Peeling force(N) | | 3.72 | 3.10 | 3.09 | 4.38 | 3.31 | 4.36 | Ribbon not adhere |

## Claims

1. A solar cell, comprising:
a silicon substrate (10), wherein the silicon substrate has a front side and a rear side;
a finger electrode (50a) formed on the front side of the silicon substrate wherein the finger electrode is in electric contact with the silicon substrate, wherein the finger electrode comprises a silver component and a glass binder, and wherein the finger electrode is substantively free of other conductive metals than the silver component; and
a busbar electrode (50b) formed on the front side of the silicon substrate wherein the busbar electrode is in electric contact with the finger electrode and wherein the busbar electrode comprises: a silver component; a second metal selected from the group consisting of nickel, copper, alloys thereof, and mixtures thereof; and a glass binder.

2. A solar cell of claim 1, wherein the second metal is nickel.

3. A solar cell of claim 1, wherein the second metal is copper.

4. A solar cell of claim 1, wherein the finger electrode comprises 80 to 99.5 wt% of the silver component and 0.5 to 20 wt% of the glass binder based on total weight of the finger electrode.

5. A solar cell of claim 1, wherein the busbar electrode comprises 74 to 98 wt % of the silver component, 2 to 25 wt% of the second metal and 0.1 to 3 wt% of the glass binder based on total weight of the busbar electrode.

6. A solar cell of claim 1, wherein content of the glass binder in the finger electrode is higher than content of the glass binder in the busbar electrode.

7. A method for manufacturing a solar cell, comprising the steps of:
preparing a silicon substrate (10), wherein the silicon substrate has a front side and a rear side;
applying a first conductive paste for forming a busbar electrode (50b) on the front side of the silicon substrate, wherein the first conductive paste comprises (a) 68 to 88 wt% of a silver component; (b) 1 to 30 wt% of a metal powder selected from the group consisting of nickel, copper, alloys thereof, and mixtures thereof; (c) 0.1-3.3wt% of a glass binder, and (d) 3 to 23 wt% of an organic vehicle-, wherein wt% is based on the total weight of the paste composition;
applying a second conductive paste for forming a finger electrode (50a) on the front side of the silicon substrate, wherein the conductive paste comprises (a) 70 to 95 wt% of a silver component; (b) 0.6 to 7 wt% of a glass binder; and (c) 3 to 23 wt% of an organic vehicle; wherein wt% is based on the total weight of the paste composition , wherein the second conductive paste for the finger electrode is substantively free of conductive metals other than the silver component; and
firing the applied conductive pastes to form the finger electrode and the busbar electrode on the front side of the silicon substrate.

8. A method for manufacturing solar cells according to claim 7, wherein content of the glass binder in the second conductive paste for the finger electrode is higher than content of the glass binder in the first conductive paste for the busbar electrode.

9. A method for manufacturing solar cells according to claim 7, wherein average diameter of the second metal powder is 0.1µm to 10µm.

10. A method for manufacturing solar cells according to claim 7, wherein the first conductive paste is applied subsequent to the application of the second conductive paste.

11. A method for manufacturing solar cells according to claim 7, wherein the second conductive paste is applied subsequent to the application of the first conductive paste.

## Patentansprüche

1. Solarzelle, Folgendes umfassend:
ein Silizium-Substrat (10),
wobei das Silizium-Substrat eine Vorderseite und eine Rückseite aufweist;
eine Fingerelektrode (50a), die auf der Vorderseite des Silizium-Substrats ausgebildet ist,
wobei die Fingerelektrode in elektrischem Kontakt mit dem Silizium-Substrat steht, wobei die Fingerelektrode eine Silber-Komponente und ein Glasbindemittel umfasst und wobei die Fingerelektrode im Wesentlichen frei von anderen leitfähigen Metallen als der Silber-Komponente ist; und
eine Sammelelektrode (50b), die auf der Vorderseite des Silizium-Substrats ausgebildet ist,
wobei die Sammelelektrode in elektrischem Kontakt mit der Fingerelektrode steht und wobei die Sammelelektrode Folgendes umfasst: eine Silber-Komponente; ein zweites Metall, das aus der Gruppe ausgewählt ist, bestehend aus Nickel, Kupfer, Legierungen davon und Mischungen davon; und einem Glasbindemittel.

2. Solarzelle nach Anspruch 1, wobei das zweite Metall Nickel ist.

3. Solarzelle nach Anspruch 1, wobei das zweite Metall Kupfer ist.

4. Solarzelle nach Anspruch 1, wobei die Fingerelektrode 80 bis 99,5 Masse-% der Silber-Komponente und 0,5 bis 20 Masse-% des Glasbindemittels basierend auf der Gesamtmasse der Fingerelektrode umfasst.

5. Solarzelle nach Anspruch 1, wobei die Sammelelektrode 74 bis 98 Masse-% der Silber-Komponente, 2 bis 25 Masse-% des zweiten Metalls und 0,1 bis 3 Masse-% des Glasbindemittels basierend auf der Gesamtmasse der Sammelelektrode umfasst.

6. Solarzelle nach Anspruch 1, wobei ein Gehalt des Glasbindemittels in der Fingerelektrode höher ist als ein Gehalt des Glasbindemittels in der Sammelelektrode.

7. Verfahren zum Herstellen einer Solarzelle, die folgenden Schritte umfassend:
Herstellen eines Silizium-Substrats (10), wobei das Silizium-Substrat eine Vorderseite und eine Rückseite aufweist;
Aufbringen einer ersten Leitpaste zum Ausbilden einer Sammelelektrode (50b) auf der Vorderseite des Silizium-Substrats, wobei die erste Leitpaste (a) 68 bis 88 Masse-% einer Silber-Komponente; (b) 1 bis 30 Masse-% eines Metallpulvers, das aus der Gruppe ausgewählt ist, bestehend aus Nickel, Kupfer, Legierungen davon und Mischungen davon; (c) 0,1 bis 3,3 Masse-% eines Glasbindemittels; und (d) 3 bis 23 Masse-% eines organischen Trägers umfasst; wobei Masse-% auf der Gesamtmasse der Pastenzusammensetzung basiert;
Aufbringen einer zweiten Leitpaste zum Ausbilden einer Fingerelektrode (50a) auf der Vorderseite des Silizium-Substrats, wobei die Leitpaste (a) 70 bis 95 Masse-% einer Silber-Komponente; (b) 0,6 bis 7 Masse-% eines Glasbindemittels; und (c) 3 bis 23 Masse-% eines organischen Trägers umfasst; wobei Masse-% auf der Gesamtmasse der Pastenzusammensetzung basiert, wobei die zweite Leitpaste für die Fingerelektrode im Wesentlichen frei von anderen leitfähigen Metallen als der Silber-Komponente ist; und
Brennen der aufgebrachten Leitpasten, um die Fingerelektrode und die Sammelelektrode auf der Vorderseite des Silizium-Substrats auszubilden.

8. Verfahren zum Herstellen von Solarzellen nach Anspruch 7, wobei ein Gehalt des Glasbindemittels in der zweiten Leitpaste für die Fingerelektrode höher ist als ein Gehalt des Glasbindemittels in der ersten Leitpaste für die Sammelelektrode.

9. Verfahren zum Herstellen von Solarzellen nach Anspruch 7, wobei ein durchschnittlicher Durchmesser des zweiten Metallpulvers 0,1 µm bis 10 µm ist.

10. Verfahren zum Herstellen von Solarzellen nach Anspruch 7, wobei die erste Leitpaste nach der Aufbringung der zweiten Leitpaste aufgebracht wird.

11. Verfahren zum Herstellen von Solarzellen nach Anspruch 7, wobei die zweite Leitpaste nach der Aufbringung der ersten Leitpaste aufgebracht wird.

## Revendications

1. Cellule solaire, comprenant :
un substrat de silicium (10), le substrat de silicium ayant un côté avant et un côté arrière ;
une électrode de doigt (50a) formée sur le côté avant du substrat de silicium,
l'électrode de doigt étant en contact électrique avec le substrat de silicium, l'électrode de doigt comprenant un composant d'argent et un liant vitreux, et l'électrode de doigt étant sensiblement dépourvue d'autres métaux conducteurs que le composant d'argent ; et
une électrode de barre omnibus (50b) formée sur le côté avant du substrat de silicium,
l'électrode de barre omnibus étant en contact électrique avec l'électrode de doigt et l'électrode de barre omnibus comprenant : un composant d'argent ; un deuxième métal choisi dans le groupe constitué par le nickel, le cuivre, les alliages de ceux-ci, et les mélanges de ceux-ci ; et un liant vitreux.

2. Cellule solaire selon la revendication 1, dans laquelle le deuxième métal est le nickel.

3. Cellule solaire selon la revendication 1, dans laquelle le deuxième métal est le cuivre.

4. Cellule solaire selon la revendication 1, dans laquelle l'électrode de doigt comprend 80 à 99,5 % en poids du composant d'argent et 0,5 à 20 % en poids du liant vitreux, rapporté au poids total de l'électrode de doigt.

5. Cellule solaire selon la revendication 1, dans laquelle l'électrode de barre omnibus comprend 74 à 98 % en poids du composant d'argent, 2 à 25 % en poids du deuxième métal et 0,1 à 3 % en poids du liant vitreux, rapporté au poids total de l'électrode de barre omnibus.

6. Cellule solaire selon la revendication 1, dans laquelle la teneur du liant vitreux dans l'électrode de doigt est supérieure à la teneur du liant vitreux dans l'électrode de barre omnibus.

7. Procédé de fabrication d'une cellule solaire, comprenant les étapes de :
préparation d'un substrat de silicium (10), le substrat de silicium ayant un côté avant et un côté arrière ;
application d'une première pâte conductrice destinée à former une électrode de barre omnibus (50b) sur le côté avant du substrat de silicium, la première pâte conductrice comprenant (a) 68 à 88 % en poids d'un composant d'argent, (b) 1 à 30 % en poids d'une poudre métallique choisie dans le groupe constitué par le nickel, le cuivre, les alliages de ceux-ci et les mélanges de ceux-ci, (c) 0,1-3,3 % en poids d'un liant vitreux, et (d) 3 à 23 % en poids d'un véhicule organique, le pourcentage pondéral se rapportant au poids total de la composition de pâte ;
application d'une deuxième pâte conductrice destinée à former une électrode de doigt (50a) sur le côté avant du substrat de silicium, la pâte conductrice comprenant (a) 70 à 95 % en poids d'un composant d'argent, (b) 0,6 à 7 % en poids d'un liant vitreux, et (c) 3 à 23 % en poids d'un véhicule organique, le pourcentage pondéral se rapportant au poids total de la composition de pâte, la deuxième pâte conductrice pour l'électrode de doigt étant sensiblement dépourvue d'autres métaux conducteurs que le composant d'argent ; et
cuisson des pâtes conductrices appliquées pour former l'électrode de doigt et l'électrode de barre omnibus sur le côté avant du substrat de silicium.

8. Procédé de fabrication de cellules solaires selon la revendication 7, dans lequel la teneur du liant vitreux dans la deuxième pâte conductrice pour l'électrode de doigt est supérieure à la teneur du liant vitreux dans la première pâte conductrice pour l'électrode de barre omnibus.

9. Procédé de fabrication de cellules solaires selon la revendication 7, dans lequel un diamètre moyen de la deuxième poudre métallique est de 0,1 µm à 10 µm.

10. Procédé de fabrication de cellules solaires selon la revendication 7, dans lequel la première pâte conductrice est appliquée après l'application de la deuxième pâte conductrice.

11. Procédé de fabrication de cellules solaires selon la revendication 7, dans lequel la deuxième pâte conductrice est appliquée après l'application de la première pâte conductrice.
